# EUROPEAN PATENT SPECIFICATION

(11) **EP 3 420 584 B1**
(45) Date of publication and mention of the grant of the patent: **23.12.2020**
(21) Application number: 16891829.0
(22) Date of filing: 25.02.2016
(51) Int. Cl.: H01L 21/768, H01L 23/532

(54) **METHODS OF FABRICATING CONDUCTIVE CONNECTORS HAVING A RUTHENIUM/ALUMINUM-CONTAINING LINER**
VERFAHREN ZUR HERSTELLUNG LEITENDER VERBINDUNGEN MIT RUTHENIUM-/ALUMINIUMHALTIGEN LINERSCHICHTEN
PROCÉDÉS DE FABRICATION D'INTERCONNEXIONS COMPRENANT UNE DOUBLURE CONTENANT DU RUTHÉNIUM/DE L'ALUMINIUM

(43) Date of publication of application: 02.01.2019
(73) Proprietor: INTEL Corporation, Santa Clara, CA 95054 (US)
(72) Inventor: JEZEWSKI, Christopher J., Portland OR 97229 (US); CHEBIAM, Ramanan V., Hillsboro, Oregon 97124 (US); CHAWLA, Jasmeet S., Hillsboro, Oregon 97124 (US); KOBRINSKY, Mauro J., Portland OR 97229 (US); CLARKE, James S., Portland, Oregon 97229 (US)
(74) Representative: HGF
(86) International application number: PCT/US2016/019617
(87) International publication number: WO 2017/146713

(56) References cited:
- US-A1- 2006 246 699
- US-A1- 2007 059 502
- US-A1- 2008 042 281
- US-A1- 2008 213 994
- US-A1- 2011 017 499
- US-A1- 2012 070 981
- US-A1- 2014 299 988
- US-A1- 2014 361 436
- US-A1- 2015 056 385

## Description

### TECHNICAL FIELD

Embodiments of the present description relate to the field of microelectronic devices, and, more particularly, to the fabricating conductive connectors, such as contact structures and conductive routes, used in the formation of microelectronic devices.

### BACKGROUND

The microelectronic industry is continually striving to produce ever faster and smaller microelectronic devices for use in various electronic products, including, but not limited to portable products, such as portable computers, digital cameras, electronic tablets, cellular phones, and the like. As the size of components, such as microelectronic dice and microelectronic substrates, are reduced, the size of conductive connectors, such as contact structures and conductive routes (conductive traces and conductive vias), must also be reduced. However, the reduction of the size of the conductive connectors may result high resistivity due to voids forming in the conductive connectors due to poor metal adhesion and/or poor gap filling. Such high resistivity may result in the electrical connectors being incapable of carrying effective electrical signals for the operation of the microelectronic devices. Therefore, there is a need to develop conductive connectors and methods of fabrication of the same which are capable of carrying effective electrical signals.

The documents US2015/056385, US2008/042281 and US2014/299988 disclose various prior art methods for forming liner layers containing ruthenium and aluminum.

### BRIEF DESCRIPTION OF THE DRAWINGS

The subject matter of the present disclosure is particularly pointed out and distinctly claimed in the concluding portion of the specification. The foregoing and other features of the present disclosure will become more fully apparent from the following description and appended claims, taken in conjunction with the accompanying drawings. It is understood that the accompanying drawings depict only several embodiments in accordance with the present disclosure and are, therefore, not to be considered limiting of its scope. The present disclosure will be described with additional specificity and detail through use of the accompanying drawings, such that the advantages of the present disclosure can be more readily ascertained, in which:
FIGs. 1-8 illustrate side cross sectional views of a method of forming a conductive connector, according to an embodiment of the present description.
FIG. 9 illustrates a side cross sectional view of a conductive connector formed by an alternate method, according to an embodiment of the present description.
FIG. 10 illustrates a side cross sectional view of a conductive connector formed by another alternate method, according to an embodiment of the present description.
FIG. 11 illustrates a side cross sectional view of a conductive connector, according to another embodiment of the present description.
FIG. 12 illustrates a computing device in accordance with one implementation of the present description.

### DESCRIPTION OF EMBODIMENTS

In the following detailed description, reference is made to the accompanying drawings that show, by way of illustration, specific embodiments in which the claimed subject matter may be practiced. These embodiments are described in sufficient detail to enable those skilled in the art to practice the subject matter. References within this specification to "one embodiment" or "an embodiment" mean that a particular feature, structure, or characteristic described in connection with the embodiment is included in at least one implementation encompassed within the present description. Therefore, the use of the phrase "one embodiment" or "in an embodiment" does not necessarily refer to the same embodiment. The following detailed description is, therefore, not to be taken in a limiting sense, and the scope of the subject matter is defined only by the appended claims, appropriately interpreted, along with the full range of equivalents to which the appended claims are entitled. In the drawings, like numerals refer to the same or similar elements or functionality throughout the several views, and that elements depicted therein are not necessarily to scale with one another, rather individual elements may be enlarged or reduced in order to more easily comprehend the elements in the context of the present description.

The terms "over", "to", "between" and "on" as used herein may refer to a relative position of one layer or component with respect to other layers or components. One layer/component "over" or "on" another layer/component or bonded "to" another layer/component may be directly in contact with the other layer/component or may have one or more intervening layers/components. One layer/component "between" layers/components may be directly in contact with the layers/components or may have one or more intervening layers/components.

Microelectronic devices are generally fabricated from various microelectronic components, including, but not limited to, at least one microelectronic die (such as a microprocessor, a chipset, a graphics device, a wireless device, a memory device, an application specific integrated circuit, or the like), at least one passive component (such as resistors, capacitors, inductors and the like), and at least one microelectronic substrate (such as interposers, motherboards, and the like) for mounting the components. Electrical signals, power delivery, and ground lines are provided through conductive connectors that may be formed in or on the microelectronic components. As will be understood to those skilled in the art, such conductive connectors may including contact structures (such as contact structures that deliver electrical signals to a gate electrode), conductive route structures (such as a plurality of conductive traces formed on layers of dielectric material that are connected by conductive vias) for the interconnection of various microelectronic components, or any other structures that may be used for electrical signals, power delivery, and/or ground lines.

Current methods of forming conductive connectors for a microelectronic structure involve forming multiple material layers within a via in a dielectric layer. For example, a barrier layer may be formed from a tantalum nitride layer followed by a layer of tantalum. After the formation of the barrier layer, a copper alloy layer may be deposited on the barrier layer, followed by a copper seed layer. From the copper seed layer, the via may be filled with copper, such as by plating. However, having multiple layers make it difficult scale down, as voiding may occur. As will be understood to those skilled in the art, voiding may increase the resistance of a conductive connector relative to a conductive connector having no voids.

Embodiments of the present description include a conductive connector for a microelectronic structure formed in an opening in a dielectric layer, wherein the conductive connector includes a ruthenium/aluminum-containing liner disposed between the dielectric layer and a substantially aluminum-free copper fill material within the opening. The ruthenium/aluminum-containing liner may be formed by depositing a ruthenium-containing liner and migrating aluminum into the ruthenium-containing liner with an annealing process. The aluminum may be presented as a layer formed either before or after the deposition of a copper fill material, or may be presented within a copper/aluminum alloy fill material wherein the annealing process migrates the aluminum out of the copper/aluminum alloy and into the ruthenium-containing liner. In further embodiments of the present description, the conductive connector may have a barrier layer disposed between the ruthenium/aluminum liner and dielectric layer of the microelectronic structure. The use of the ruthenium/aluminum liner may improve gapfill and adhesion due to its wetting and adhesion properties, which may result in the conductive connector being substantially free of voids. Furthermore, the utilization of aluminum in the ruthenium/aluminum liner may improve its barrier properties in preventing diffusion of the copper fill material.

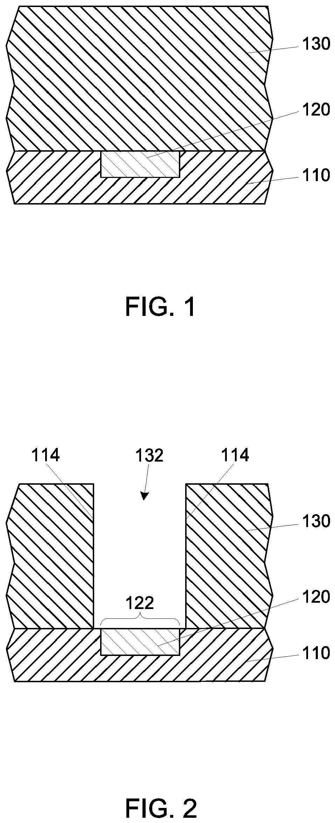

FIGs. 1-7 illustrate a method of fabricating a conductive connector according to the prior art. As shown in FIG. 1, a first dielectric material layer 110 may be formed having at least one conductive land 120 formed therein and a second dielectric material layer 130 may be formed over the first dielectric material layer 110 and the conductive land 120. The first dielectric material layer 110 and the second dielectric material layer 130 may be any appropriate dielectric material, including but not limited to, silicon dioxide (SiO₂), silicon oxynitride (SiOₓN_{y}), and silicon nitride (Si₃N₄) and silicon carbide (SiC), liquid crystal polymer, epoxy resin, bismaleimide triazine resin, polyimide materials, and the like, as well as low-k and ultra low-k dielectrics (dielectric constants less than about 3.6), including but not limited to carbon doped dielectrics, fluorine doped dielectrics, porous dielectrics, organic polymeric dielectrics, silicon based polymeric dielectrics, and the like. The first dielectric material layer 110 and the second dielectric material layer 130 may be formed by any known technique, including, but not limited, chemical vapor deposition, physical vapor deposition, coating, lamination, and the like.

It is understood that the conductive land 120 could be any appropriate microelectronic structure. The conductive land 120 may be a transistor structure, such as a transistor gate electrode. In this case, the conductive land 120 may be a workfunction metal, including, but not limited to, titanium, aluminum, tantalum, zirconium, and the like. In another example, the conductive land 120 may be a part of a conductive route structure, such as a front end and/or back end metallization. In this case, the conductive land 120 may include, but is not limited to, copper, silver, nickel, gold, aluminum, tungsten, cobalt, and alloys thereof, and the like.

As shown in FIG. 2, at least one opening 132, such as a trench or a via, may be formed through the second dielectric material layer 130 to expose at least a portion 122 of the conductive land 120. As will be understood to those skilled in the art, the opening 132 may be a part of and extend from a trench. The openings 132 may be formed by any known technique, such as photolithography, etching, and laser ablation. It is understood that an etch stop layer (not shown) may be formed over the first dielectric material layer 110 and the conductive land 120, and the second dielectric material layer 130 may be formed over the etch stop layer (not shown). The processes and materials used and the purpose for forming the etch stop layer (not shown) are well known in the art, and, for the sake of brevity and conciseness, will not be described or illustrated herein.

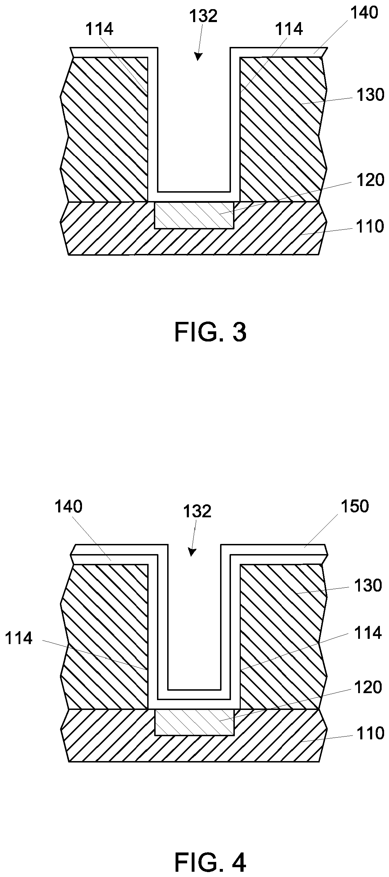

As shown in FIG. 3, a barrier layer 140 may be formed on sidewalls 114 of the opening 132, as well as on the exposed portion 122 (see FIG. 2) of the conductive land 120. The barrier layer 140 may be made of any appropriate material, including but not limited to, titanium, tantalum, tungsten, manganese, niobium, molybdenum, and cobalt, as well as nitrides, borides, carbides, and silicides thereof. The barrier layer 140 may be formed by any known process, including but not limited to physical vapor deposition, chemical vapor deposition, atomic layer deposition, electroless plating, electroplating, and the like. The barrier layer 140 may be formed by a conformal deposition process resulting in a substantially conformal barrier layer 140. Although the barrier layer 140 is illustrated as a single layer, it is understood that the barrier layer 140 may be a plurality of layers. As will be understood to those skilled in the art, the barrier layer 140 may be used to prevent subsequently deposited materials from migrating into the first dielectric material layer 110 and the second dielectric material layer 130.

As shown in FIG. 4, a ruthenium-containing liner 150 may be formed on the barrier layer 140. The ruthenium-containing liner 150 may be deposited by any known process, including but not limited to physical vapor deposition, chemical vapor deposition, atomic layer deposition, electroless plating, electroplating, and the like. The ruthenium-containing liner 150 may be formed by a conformal deposition process resulting in a substantially conformal ruthenium-containing liner 150. It is understood, that the ruthenium-containing liner 150 may be used for its high adhesion and wetting properties for a subsequently deposited copper fill material, as will be discussed. In one example, the ruthenium-containing liner 150 is substantially pure ruthenium.

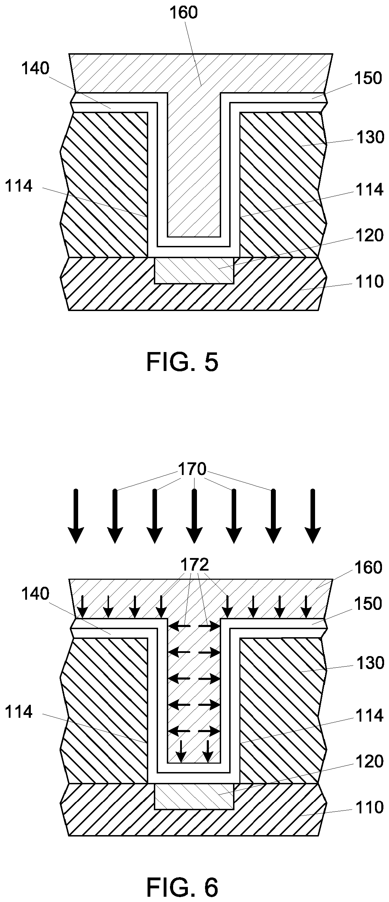

As shown in FIG. 5, a copper/aluminum alloy fill material 160 may be deposited in the opening 132 (see FIG. 4) to abut the ruthenium-containing liner 150. The copper/aluminum alloy fill material 160 may be formed by any known process, including but not limited to physical vapor deposition, chemical vapor deposition, atomic layer deposition, electroless plating, electroplating, and the like. In one example, the copper/alloy fill material 160 may comprise an aluminum content of between about 1% and 20% atomic.

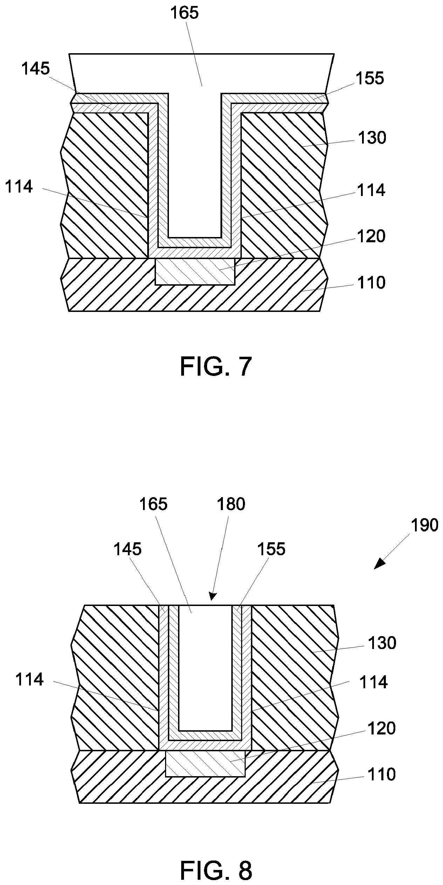

As shown in FIG. 6, the copper/aluminum alloy fill material 160 may be annealed/heated (shown as arrows 170) to migrate (shown as arrows 172) the aluminum within the copper/aluminum alloy fill material 160 into the ruthenium-containing liner 150. The migration of the aluminum 172, as shown in FIG. 6 forms, a ruthenium/aluminum-containing liner 155 and a substantially aluminum-free copper fill material 165, as shown in FIG. 7. For the purposes for the present description, the term "substantially aluminum-free" is defined to mean an aluminum content of less than about 3% atomic. Furthermore, the annealing 170 may also result in the migration of the aluminum into the barrier layer 140 to form an aluminum-containing barrier layer 145. The annealing 170 may be performed at a temperature of between about 250°C and 400°C for a sufficient duration of time to effectuate the aluminum migration. It noted that the shading in the copper/aluminum alloy fill material 160 (see FIG. 5) has been transferred into the ruthenium/aluminum-containing liner 155 and the aluminum-containing barrier layer 145 to represent the transfer of the aluminum.

As shown in FIG. 8, any portion of the substantially aluminum-free copper fill material 165, the ruthenium/aluminum-containing liner 155, and/or the aluminum-containing barrier layer 145 which may extend over the second dielectric material layer 120 outside of the opening 132 (see FIG. 6) may be removed, such as by chemical mechanical polishing, to form at least one conductive connector 180 for a microelectronic structure 190.

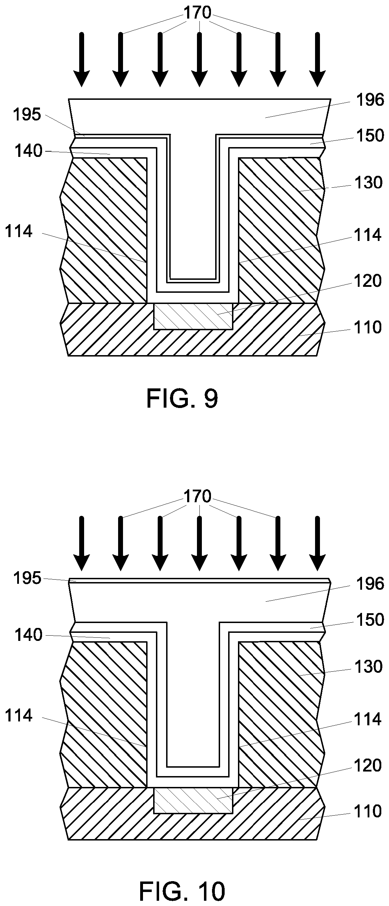

In an embodiment of the present invention, beginning with FIG. 5, an aluminum layer 195 may be deposited on the ruthenium-containing liner 150 followed by the deposition of a copper fill material 196, as shown in FIG. 9. As further shown in FIG. 9, an annealing 170 may be performed, as previously discussed, to form the ruthenium/aluminum-containing liner 155 and the substantially aluminum-free copper fill material 165, as shown in FIG. 7. According to the invention, the annealing 170 is performed prior to the deposition of the copper fill material 196.

In another embodiment, beginning with FIG. 5, the copper fill material 196 may be deposited to abut the ruthenium-containing liner 150 followed by the deposition of the aluminum layer 195 on copper fill material 196, as shown in FIG. 10. As further shown in FIG. 10, an annealing 170 may be performed, as previously discussed, which migrates the aluminum layer 195 through the copper fill material 196 to form the ruthenium/aluminum-containing liner 155 and the substantially aluminum-free copper fill material 165, as shown in FIG. 7.

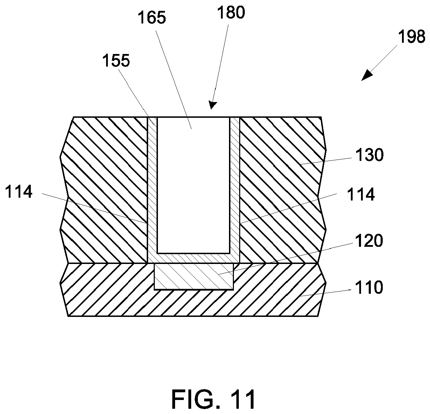

In still another embodiment, the ruthenium/aluminum-containing liner 155, as shown in FIG. 6, may also act as a barrier layer, i.e. prevent subsequently deposited materials from migrating into the first dielectric material layer 110 and the second dielectric material layer 130, such that a barrier layer is not required. Thus, all of the previously described processes may be followed, with the exception of forming the barrier layer 140 (see FIG. 4) and/or the aluminum-containing barrier layer 145 (see FIG. 6), to form a microelectronic structure 198, wherein the ruthenium/aluminum-containing liner 155 abuts the second dielectric material layer 130, the conductive land 120, and/or the first dielectric material layer 110, as shown in FIG. 11.

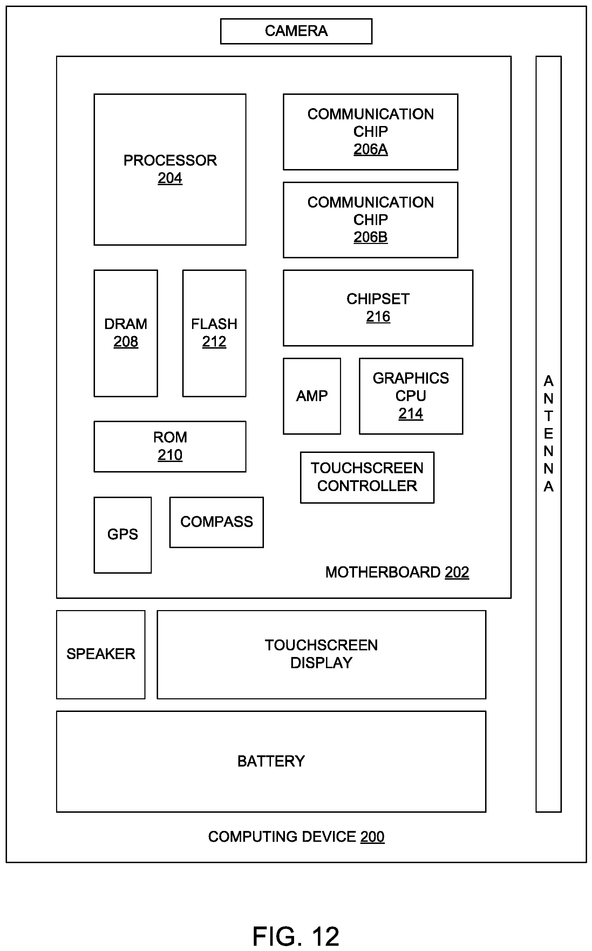

FIG. 12 illustrates a computing device 200 in accordance with one implementation of the present description. The computing device 200 houses a board 202. The board may include a number of microelectronic components, including but not limited to a processor 204, at least one communication chip 206A, 206B, volatile memory 208, (e.g., DRAM), nonvolatile memory 210 (e.g., ROM), flash memory 212, a graphics processor or CPU 214, a digital signal processor (not shown), a crypto processor (not shown), a chipset 216, an antenna, a display (touchscreen display), a touchscreen controller, a battery, an audio codec (not shown), a video codec (not shown), a power amplifier (AMP), a global positioning system (GPS) device, a compass, an accelerometer (not shown), a gyroscope (not shown), a speaker (not shown), a camera, and a mass storage device (not shown) (such as hard disk drive, compact disk (CD), digital versatile disk (DVD), and so forth). Any of the microelectronic components may be physically and electrically coupled to the board 202. In some implementations, at least one of the microelectronic components may be a part of the processor 204.

The communication chip enables wireless communications for the transfer of data to and from the computing device. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device may include a plurality of communication chips. For instance, a first communication chip may be dedicated to shorter range wireless communications such as Wi-Fi and Bluetooth and a second communication chip may be dedicated to longer range wireless communications such as GPS, EDGE, GPRS, CDMA, WiMAX, LTE, Ev-DO, and others.

The term "processor" may refer to any device or portion of a device that processes electronic data from registers and/or memory to transform that electronic data into other electronic data that may be stored in registers and/or memory.

Any of the microelectronic components within the computing device 400 may include a microelectronic structure comprising a dielectric material layer over a conductive land, an opening extending through the dielectric material layer to a portion of the conductive land, a ruthenium/aluminum-containing liner adjacent at least one sidewall of the opening and adjacent the conductive land, and a substantially aluminum-free copper fill material abutting the ruthenium/aluminum-containing liner.

In various implementations, the computing device may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device may be any other electronic device that processes data.

It is understood that the subject matter of the present description is not necessarily limited to specific applications illustrated in FIGs. 1-11. The subject matter may be applied to other microelectronic device and assembly applications, as will be understood to those skilled in the art.

## Claims

1. A method of fabricating a microelectronic structure (190), comprising:
forming a dielectric material layer (130) over a conductive land (120);
forming an opening (132) through the dielectric material layer (130) to expose at least a portion of the conductive land (120);
forming a ruthenium/aluminum-containing liner (150) adjacent at least one sidewall (114) of the opening (132) and adjacent the exposed portion (122) of the conductive land; and
forming an aluminum-free copper fill material (165) comprising less than 3% atomic aluminium abutting the ruthenium/aluminum-containing liner (150);
wherein forming the ruthenium/aluminum-containing liner (150) and forming the aluminum-free copper fill material (165) comprises:
depositing a ruthenium-containing liner (150) adjacent the at least one sidewall (114) of the opening (132);
depositing an aluminum layer (195) abutting the ruthenium-containing liner (150);
depositing a copper fill material (196) abutting the ruthenium-containing liner (150); and annealing the aluminum layer (195) to migrate it into the ruthenium-containing liner (196);
**characterized in that** annealing the aluminum layer (195) occurs prior to depositing the copper fill material (196).

2. The method of claim 1, further including forming a barrier layer (140) between the opening sidewalls (114) and the ruthenium/aluminum-containing liner (150).

3. The method of claim 1, wherein annealing the aluminum layer (195) migrates a portion thereof into the barrier layer (150).

4. A method of fabricating a microelectronic structure (190), comprising:
forming a dielectric material layer (130) over a conductive land (120);
forming an opening (132) through the dielectric material layer (130) to expose at least a portion of the conductive land (120);
forming a ruthenium/aluminum-containing liner (150) adjacent at least one sidewall (114) of the opening (132) and adjacent the exposed portion (122) of the conductive land; and
forming an aluminum-free copper fill material (165) comprising less than 3% atomic aluminium abutting the ruthenium/aluminum-containing liner (150);
**characterized in that** forming the ruthenium/aluminum-containing liner (150) and forming the aluminum-free copper fill material (165) comprises:
depositing a ruthenium-containing liner (150) adjacent the at least one sidewall (114) of the opening (132);
depositing a copper fill material (196) abutting the ruthenium-containing liner (150);
depositing an aluminum layer (195) abutting the copper fill material (196); and
annealing the aluminum layer (195) to migrate it through the copper fill material (196) and into the ruthenium-containing liner (150).

5. The method of claim 4, further including forming a barrier layer (140) between the opening sidewalls (114) and the ruthenium/aluminum-containing liner (150).

6. The method of claim 5, wherein annealing the aluminum layer (195) migrates a portion thereof into the barrier layer (140).

## Patentansprüche

1. Verfahren zum Erzeugen einer mikroelektronischen Struktur (190), das Folgendes umfasst:
Bilden einer Schicht aus dielektrischem Material (130) über einer leitenden Fläche (120);
Bilden einer Öffnung (132) durch die Schicht aus dielektrischem Material (130), um zumindest einen Teil der leitenden Fläche (120) freizulegen;
Bilden einer ruthenium-/aluminiumhaltigen Auskleidung (150) angrenzend an mindestens eine Seitenwand (114) der Öffnung (132) und angrenzend an den freigelegten Teil (122) der leitenden Fläche; und
Bilden eines aluminiumfreien Kupferfüllmaterials (165), das weniger als 3 % atomares Aluminium enthält und das an die ruthenium-/aluminiumhaltige Auskleidung (150) anstößt;
wobei das Bilden der ruthenium-/aluminiumhaltigen Auskleidung (150) und das Bilden des aluminiumfreien Kupferfüllmaterials (165) Folgendes umfasst:
Aufbringen einer rutheniumhaltigen Auskleidung (150) angrenzend an mindestens eine Seitenwand (114) der Öffnung (132);
Aufbringen einer Aluminiumschicht (195), die an die rutheniumhaltige Auskleidung (150) anstößt;
Aufbringen eines Kupferfüllmaterials (196), das an die rutheniumhaltige Auskleidung (150) anstößt; und Tempern der Aluminiumschicht (195), um sie in die rutheniumhaltige Auskleidung (196) zu migrieren;
**dadurch gekennzeichnet, dass**
das Tempern der Aluminiumschicht (195) vor dem Aufbringen des Kupferfüllmaterial (196) geschieht.

2. Verfahren nach Anspruch 1, das ferner enthält, eine Barrierenschicht (140) zwischen den öffnenden Seitenwänden (114) und der ruthenium-/aluminiumhaltigen Auskleidung (150) zu bilden.

3. Verfahren nach Anspruch 1, wobei das Tempern der Aluminiumschicht (195) einen Teil von ihr in die Barrierenschicht (150) migriert.

4. Verfahren zum Erzeugen einer mikroelektronischen Struktur (190), das Folgendes umfasst:
Bilden einer Schicht aus dielektrischem Material (130) über eine leitenden Fläche (120);
Bilden einer Öffnung (132) durch die Schicht aus dielektrischem Material (130), um zumindest einen Teil der leitenden Fläche (120) freizulegen;
Bilden einer ruthenium-/aluminiumhaltigen Auskleidung (150) angrenzend an mindestens eine Seitenwand (114) der Öffnung (132) und angrenzend an den freigelegten Teil (122) der leitenden Fläche; und
Bilden eines aluminiumfreien Kupferfüllmaterials (165), das weniger als 3 % atomares Aluminium enthält und das an die ruthenium-/aluminiumhaltige Auskleidung (150) anstößt;
**dadurch gekennzeichnet, dass**
das Bilden der ruthenium-/aluminiumhaltigen Auskleidung (150) und das Bilden des aluminiumfreien Kupferfüllmaterials (165) Folgendes umfasst:
Aufbringen einer rutheniumhaltigen Auskleidung (150) angrenzend an die mindestens eine Seitenwand (114) der Öffnung (132);
Aufbringen eines Kupferfüllmaterials (196), das an die rutheniumhaltige Auskleidung (150) anstößt; und
Aufbringen einer Aluminiumschicht (195), die an das Kupferfüllmaterial (196) anstößt;
Tempern der Aluminiumschicht (195), um sie durch das Kupferfüllmaterial (196) und in die rutheniumhaltige Auskleidung (150) zu migrieren.

5. Verfahren nach Anspruch 4, das ferner enthält, eine Barrierenschicht (140) zwischen den öffnenden Seitenwänden (114) und der ruthenium-/aluminiumhaltigen Auskleidung (150) zu bilden.

6. Verfahren nach Anspruch 5, wobei das Tempern der Aluminiumschicht (195) einen Teil von ihr in die Barrierenschicht (140) migriert.

## Revendications

1. Procédé de fabrication d'une structure microélectronique (190), comprenant :
la formation d'une couche de matériau diélectrique (130) sur une pastille conductrice (120) ;
la formation d'une ouverture (132) à travers la couche de matériau diélectrique (130) pour exposer au moins une partie de la pastille conductrice (120) ;
la formation d'un revêtement contenant du ruthénium/aluminium (150) adjacent à au moins une paroi latérale (114) de l'ouverture (132) et adjacent à la partie exposée (122) de la pastille conductrice ; et
la formation d'un matériau de remplissage au cuivre dépourvu d'aluminium (165) comprenant moins de 3 % en atomes d'aluminium jouxtant le revêtement contenant du ruthénium/aluminium (150) ;
dans lequel la formation du revêtement contenant du ruthénium/aluminium (150) et la formation du matériau de remplissage au cuivre dépourvu d'aluminium (165) comprennent :
le dépôt d'un revêtement contenant du ruthénium (150) adjacent à l'au moins une paroi latérale (114) de l'ouverture (132) ;
le dépôt d'une couche d'aluminium (195) jouxtant le revêtement contenant du ruthénium (150) ;
le dépôt d'un matériau de remplissage au cuivre (196) jouxtant le revêtement contenant du ruthénium (150) ; et
le recuit de la couche d'aluminium (195) pour la faire migrer à l'intérieur du revêtement contenant du ruthénium (196) ;
**caractérisé en ce que**
le recuit de la couche d'aluminium (195) se produit avant le dépôt du matériau de remplissage au cuivre (196).

2. Procédé de la revendication 1, comportant en outre la formation d'une couche barrière (140) entre les parois latérales d'ouverture (114) et le revêtement contenant du ruthénium/aluminium (150).

3. Procédé de la revendication 1, dans lequel le recuit de la couche d'aluminium (195) fait migrer une partie de celle-ci à l'intérieur de la couche barrière (150).

4. Procédé de fabrication d'une structure microélectronique (190), comprenant :
la formation d'une couche de matériau diélectrique (130) sur une pastille conductrice (120) ;
la formation d'une ouverture (132) à travers la couche de matériau diélectrique (130) pour exposer au moins une partie de la pastille conductrice (120) ;
la formation d'un revêtement contenant du ruthénium/aluminium (150) adjacent à au moins une paroi latérale (114) de l'ouverture (132) et adjacent à la partie exposée (122) de la pastille conductrice ; et
la formation d'un matériau de remplissage au cuivre dépourvu d'aluminium (165) comprenant moins de 3 % en atomes d'aluminium jouxtant le revêtement contenant du ruthénium/aluminium (150) ;
**caractérisé en ce que**
la formation du revêtement contenant du ruthénium/aluminium (150) et la formation du matériau de remplissage au cuivre dépourvu d'aluminium (165) comprennent :
le dépôt d'un revêtement contenant du ruthénium (150) adjacent à l'au moins une paroi latérale (114) de l'ouverture (132) ;
le dépôt d'un matériau de remplissage au cuivre (196) jouxtant le revêtement contenant du ruthénium (150) ;
le dépôt d'une couche d'aluminium (195) jouxtant le matériau de remplissage au cuivre (196) ; et
le recuit de la couche d'aluminium (195) pour la faire migrer à travers le matériau de remplissage au cuivre (196) et à l'intérieur du revêtement contenant du ruthénium (150).

5. Procédé de la revendication 4, comportant en outre la formation d'une couche barrière (140) entre les parois latérales d'ouverture (114) et le revêtement contenant du ruthénium/aluminium (150).

6. Procédé de la revendication 5, dans lequel le recuit de la couche d'aluminium (195) fait migrer une partie de celle-ci à l'intérieur de la couche barrière (140) .
